# EUROPÄISCHE PATENTSCHRIFT

(11) **EP 3 374 232 B1**
(45) Veröffentlichungstag und Bekanntmachung des Hinweises auf die Patenterteilung: **27.11.2019**
(21) Anmeldenummer: 16794925.4
(22) Anmeldetag: 28.10.2016
(51) Int. Cl.: B60Q 1/04, H01L 33/50, H01L 33/64, F21K 9/64, C09K 11/77, C23C 16/27, C01B 32/26, F21S 41/14, F21S 45/47, F21S 41/16

(54) **KONVERTER FÜR LEUCHTVORRICHTUNGEN**
CONVERTER FOR LIGHTING DEVICES
CONVERTISSEUR POUR DISPOSITIFS LUMINEUX

(30) Priorität: 11.11.2015 AT 509642015
(43) Veröffentlichungstag der Anmeldung: 19.09.2018
(73) Patentinhaber: ZKW Group GmbH, 3250 Wieselburg (AT)
(72) Erfinder: HARTMANN, Peter, 3392 Schönbühel-Aggsbach (AT)
(74) Vertreter: Patentanwaltskanzlei Matschnig & Forsthuber OG
(86) Internationale Anmeldenummer: PCT/AT2016/060092
(87) Internationale Veröffentlichungsnummer: WO 2017/079773

(56) Entgegenhaltungen:
- EP-A1- 1 536 043
- WO-A1-2013/144053
- WO-A2-2014/095906
- DE-A1-102008 027 339
- US-A1- 2014 072 812

## Beschreibung

Die Erfindung betrifft einen Konverter für eine Leuchtvorrichtung, insbesondere für eine Leuchtvorrichtung für einen Kraftfahrzeugscheinwerfer, wobei der Konverter ein Konvertermaterial zur zumindest teilweisen Umwandlung eines von einer Primärlichtquelle ausgestrahlten Primärlichts in ein Sekundärlicht aufweist, wobei das Sekundärlicht eine unterschiedliche Wellenlänge als das Primärlicht aufweist.

Die Erfindung betrifft ferner Leuchtvorrichtungen sowie Kraftfahrzeugscheinwerfer und Signalleuchten umfassend einen erfindungsgemäßen Konverter. Die Erfindung betrifft außerdem Verfahren zum Herstellen der erfindungsgemäßen Konverter.

Der Einsatz von Laserlichtquellen in Kraftfahrzeugen gewinnt derzeit an Bedeutung, da insbesondere Laserdioden flexiblere und effizientere Lösungen ermöglichen, wodurch auch die Leuchtdichte des Lichtbündels sowie die Lichtausbeute erheblich gesteigert werden kann.

Bei den bekannten Lösungen wird allerdings kein direkter Laserstrahl emittiert, um eine Gefährdung von Menschen und anderen Lebewesen, insbesondere von Augen, durch den extrem gebündelten Lichtstrahl hoher Leistung zu vermeiden. Der Laserstrahl wird vielmehr auf einen zwischengeschalteten Konverter, der ein Lumineszenzkonvertermaterial, kurz "Phosphor" genannt, enthält, geleitet und von diesem von z.B. blauem Licht in vorzugsweise "weißes" Licht umgewandelt, insbesondere so, dass in Überlagerung mit der gestreuten Laserstrahlung ein gesetzeskonformer Weißlichteindruck entsteht.

In Zusammenhang mit der vorliegenden Erfindung wird unter dem Begriff "Konvertermaterial" bzw. "Phosphor" ganz allgemein ein Stoff oder eine Stoffmischung verstanden, welche Licht einer Wellenlänge in Licht einer anderen Wellenlänge oder eines Wellenlängengemisches, insbesondere in "weißes" Licht, umwandelt, was unter dem Begriff "Wellenlängenkonversion" subsumierbar ist. Dabei wird unter "weißes Licht" Licht einer solchen Spektralzusammensetzung verstanden, welches beim Menschen den Farbeindruck "weiß" hervorruft. Der Begriff "Licht" ist natürlich nicht auf für das menschliche Auge sichtbare Strahlung eingeschränkt.

Als Konvertermaterial sind Optokeramiken bekannt geworden, das sind transparente Keramiken, wie beispielsweise YAG-Ce (ein Yttrium-Aluminium-Granat mit Cer dotiert).

Lichtkonverter, insbesondere für Leuchtvorrichtungen für Kraftfahrzeugscheinwerfer, sind aus dem Stand der Technik hinlänglich bekannt.

Bekannte Lichtkonverter sind häufig aus einer Schichtstruktur umfassend einen Träger (meist Saphir) und eine Konvertermaterialschicht aufgebaut.

Die WO 2015004005 A1 offenbart ein Konversionselement mit einer Trennstruktur und einer Vielzahl von Konversionsbereichen, wobei jeder Konversionsbereich von einem Teil der Trennstruktur zumindest teilweise umschlossen ist und wobei jeder Konversionsbereich dazu ausgebildet ist, elektromagnetische Primärstrahlung wenigstens teilweise in eine Sekundärstrahlung mit einer größeren Wellenlänge umzuwandeln. Das Konversionselement kann beispielsweise einem LED-Array zugeordnet sein.

DIE US 2015/01027322 A1 beschreibt ein Konversionselement, das durch Screen Printing hergestellt wird und aus regelmäßig angeordneten fluoreszierenden Bereichen besteht, deren Zwischenräume mit einem flexiblen Gel oder Fluid aufgefüllt sind. Das flexible Gel dient dem Ausgleich von thermomechanischen Spannungen unter Temperaturbelastung.

Die EP 2 063 170 A2 offenbart eine Beleuchtungsvorrichtung für ein Fahrzeug mit zumindest einer Lichtquelle und zumindest einem im Strahlengang der Lichtquelle angeordneten optischen Abbildungselement, wobei zwischen der Lichtquelle und dem Abbildungselement ein Flächenelement angeordnet ist, welches zumindest zur Ausleuchtung der Brennebene des Abbildungselements ausgebildet ist. Das Flächenelement kann unter anderem ein Lichtkonverter mit begrenzten Flächensegmenten sein.

Die US 2011/0249460 A1 offenbart ein Projektionssystem mit einer Lichtquelle, einem "Phosphor"-Element und einer Projektionslinse.

Die DE 10 2013 102 205A1 beschreibt eine Beleuchtungseinrichtung für ein Kraftfahrzeug, mit mindestens einer Laserstrahlungsquelle, die mindestens eine auf einer Trägereinrichtung angebrachte Leuchtstoffschicht zu einer Lichtemission mit einer Wellenlängenkonversion anregt. Die Leuchtstoffschicht ist in einzelne Pixel unterteilt.

Die WO 2014/095906 A2 offenbart eine Scheinwerfervorrichtung mit einer Laserlichtquelle zur Emission von kollimierter Primärstrahlung, ein Konversionselement mit Konversionsbereichen, die zur zumindest teilweisen Umwandlung der kollimierten Primärstrahlung in Sekundärstrahlung vorgesehen sind und im Betrieb Leuchtbereiche bilden, und Trennstege, welche die Konversionsbereiche voneinander trennen und für die Primärstrahlung und Sekundärstrahlung undurchlässig sind.

Die DE 10 2008 027 339 A1 beschreibt einen Wellenlängenkonverter mit wärmeleitender Komponente und einem Leuchtstoff, der zur zumindest teilweisen Wandlung einer elektromagnetischen Grundstrahlung in eine Zweitstrahlung mit unterschiedlicher Wellenlänge dient. Die wärmeleitende Komponente ist in einem für die Durchstrahlung vorgesehenen Bereich angeordnet und kann nach Art eines Gitters oder als Schicht ausgeführt sein. Die wärmeleitende Komponente kann eine Metall-Legierung, eine intermetallischen Verbindung, Saphir, Aluminiumnitrid, Bornitrid oder Diamant sein.

Die US 7,675,079 B1 offenbart eine ganzflächige Zwischenschicht aus Diamant zwischen einem Lichtkonversionsbereich und einer SiC-Leuchtdiode. Die Diamantschicht ermöglicht eine gleichmäßige Anpassung des Brechungsindex von hohen Werten der SiC-Diode auf die niedrigeren Werte des Lichtkonversionsbereichs. Dadurch kann mehr UV-Licht in den Lichtkonversionsbereich ohne Reflexion an der Grenzfläche eintreten. Die Diamantschicht ist ganzflächig, unstruktiert und wird beispielsweise mittels chemischer Abscheidung aus der Gasphase (Chemical Vapor Deposition, CVD) abgeschieden.

Ein Problem bei bekannten Lichtkonvertern liegt darin, dass sich bei der Konversion eines intensiven, fokussierten Laserstrahls, wie er z.B. für scannende Scheinwerfer eingesetzt wird, Limitierungen bezüglich des Thermomanagements wie z.B. die Steuerung und Optimierung der Wärmeströme im Scheinwerfer, und bezüglich der erzielbaren feinen Auflösung bzw. des Kontrastverhältnisses eines konvertierten Leuchtpunktes ergeben.

Es ist eine Aufgabe der Erfindung, einen Konverter, insbesondere einen Laser-Lichtkonverter, bereitzustellen, der einerseits eine optimierte punktuelle Wärmeableitung und andererseits eine optimierte laterale Verteilung des Konvertermaterials bezüglich Strukturierung (diskrete Pixelung) und Streuwirkung und somit eine einstellbare Auflösung bzw. Kontrastwirkung ermöglicht.

Die Aufgabe wird mit einem Konverter für eine Leuchtvorrichtung wie eingangs genannt dadurch gelöst, dass der Konverter erfindungsgemäß eine flächige Diamantträgerstruktur aus polykristallinem Diamant mit einer Vielzahl an Diamantsäulenkristallen, die eine Diamantsäulentextur ausbilden, umfasst, wobei Bereiche der Diamantträgerstruktur das Konvertermaterial aufweisen und zwischen diesen Bereichen Freiräume verbleiben, die einen konversionsfreien Durchtritt des Primärlichts durch die Diamantträgerstruktur ermöglichen.

Die Erfindung basiert folglich auf der Nutzung einer flächigen Diamantträgerstruktur aus polykristallinem Diamant als kühlende und lichtpunktformende Trägereinheit für Lichtkonverter. Durch die hohe Wärmeleitfähigkeit (1600 bis > 2000 W/mK), die hohe Transparenz und den sehr hohen Brechungsindex (2,417) stellt Diamant ein optimales Trägermedium für das Konvertermaterial dar. Polykristalliner Diamant stellt einerseits eine potente Wärmesenke mit rascher punktueller Wärmeableitung dar. Andererseits ist es aufgrund der Texturierung und Topographie der Diamantträgerstruktur möglich, das Konvertermaterial mit einer gezielten Struktur (Verteilung, Schichtdicke, Körnung) aufzubringen, wobei die Wege für den Blauanteil des Sekundärlichts freigehalten werden können und die Konvertermaterialfüllung aufgrund der Fragmentierung bezüglich Temperaturwechselbeanspruchung entlastet ist. Der erfindungsgemäße Konverter ist durch die Diamantstruktur zumindest bereichsweise aufgrund der Freiräume durchlässig für das Primärlicht, so dass ein Teil des Primärlichts ohne Konversion transmittiert wird. Es wird also emittiertes Sekundärlicht mit transmittiertem Primärlicht gemischt.

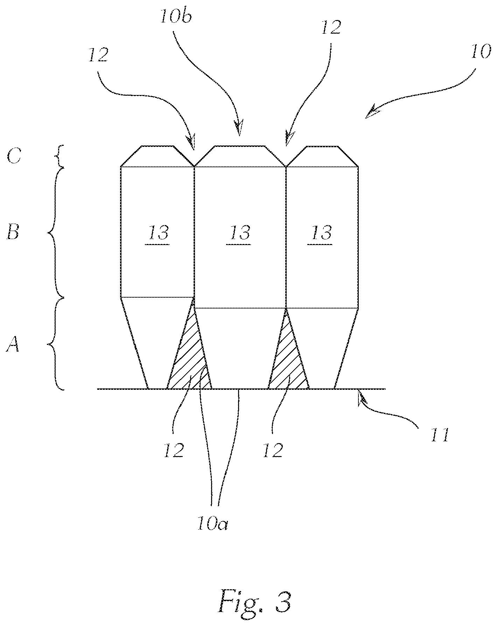

Unter dem Begriff "Topographie" ist die geometrische Beschaffenheit (Geometrie, Struktur, Höhenprofil) der Oberflächen der flächigen Diamantträgerstruktur zu verstehen, wobei die Topographie polykristalliner Diamantträgerstrukturen nach an sich bekannter Weise Zwischenräume/Täler und Erhebungen umfasst. Die flächige Diamantträgerstruktur weist folglich eine Innenfläche und eine Außenfläche auf, wobei typischerweise aufgrund der polykristallinen Diamantsäulentextur sowohl die Innenfläche als auch die Außenfläche topografische Strukturen besitzen. Im Zuge des Kristallwachstums (vgl. Fig. 3 und Beschreibung hierzu weiter unten) wachsen die einzelnen Diamantsäulenkristalle zusammen und bilden eine im Wesentlichen geschlossene Schicht aus, die idealerweise lediglich von nicht vermeidbaren Lücken im Zuge des Kristallwachstum durchbrochen ist.

Der Begriff "Innenfläche" der Diamantträgerstruktur (bzw. des Konverters) ist jene Fläche, die bei der Herstellung der polykristallinen Diamantträgerstruktur durch Wachstum auf einem Substrat dem Substrat zugewandt ist. Entsprechend ist unter der "Außenfläche" der Diamantträgerstruktur (bzw. des Konverters) jene Fläche zu verstehen, die bei der Herstellung der Diamantträgerstruktur vom Substrat abgewandt ist.

Mit Vorteil folgen die das Konvertermaterial aufweisenden Bereiche der Diamantträgerstruktur der Topografie der flächigen Diamantträgerstruktur. Dadurch ist das Konvertermaterial mit einer gezielten Struktur (Verteilung, Schichtdicke, Körnung) auf der Diamantträgerstruktur aufgebracht und diese Struktur des Konvertermaterials ist durch die Diamantträgertopografie vorgegeben. Auf diese Weise wird eine gleichartige Verteilung der Konvertermaterialbereiche und der Freiräume, die einen konversionsfreien Durchtritt des Primärlichts durch die Diamantträgerstruktur ermöglichen, erreicht.

Der erfindungsgemäße Konverter ist besonders zur Konversion von blauer Laser-Strahlung in ein multispektrales, annähernd weißes Licht in Kraftfahrzeugscheinwerferanwendungen geeignet.

Die Diamantsäulenkristalle sind in der flächigen Diamantträgerstruktur im Wesentlichen in Lichtausbreitungsrichtung ausgerichtet. In anderen Worten ausgedrückt, sind die Diamantsäulenkristalle in der flächigen Diamantträgerstruktur im Wesentlichen parallel zueinander angeordnet. Darunter fallen auch epitaktische Schichten, bei denen die Kristallsäulen zusätzlich in der Ebene parallel zum Substrat gleich ausgerichtet sind, indem die Gitterstruktur des Substrats die Gitterstruktur der Kristallsäulen über die Bekeimung hinaus bestimmt.

Die Diamantträgerstruktur wird mit Vorteil durch chemische Abscheidung aus der Gasphase (Chemical Vapor Deposition, CVD) hergestellt. Verfahren zum Herstellen polykristalliner Diamantschichten durch chemische Abscheidung aus der Gasphase sind hinlänglich bekannt. Das Kristallwachstum, die Facettierung und die Oberflächenmorphologie kann durch Steuerung der Wachstumsgeschwindigkeit der einzelnen Facetten über Prozessparameter (z.B. Temperatur, Verhältnis Kohlenwasserstoff:Wasserstoff), die Wahl des Substrats und der Keimungsbedingungen nach an sich bekannter Art kontrolliert werden (siehe z.B. Hartmann P., 1997, Dissertation TU Wien: Diamantabscheidung mit der DC-Glimmentladungsmethode sowie mit Bor- und Stickstoff-Zugabe im Hot-Filament-Verfahren; Wild et al., 1993, Diamond and Related Materials 2:158-168).

Zu Beginn der CVD-Abscheidung bilden sich auf dem Substrat isolierte Diamantkristalle unter Freibleiben von Zwischenräumen aus, die im weiteren Verlauf zu einer zusammenhängenden Schicht individueller Kristalle, die durch Korngrenzen getrennt sind, weiterwachsen. Bei weiterem Kristallwachstum bildet sich nach oben hin ein einkristalliner Bereich mit vereinzelten kurzen Defekten aus, oder das Wachstum wird nach Ausbilden von Facetten mit einer Orientierung, die von der Substratorientierung abweicht, gestoppt, um (topographische) Erhebungen und Vertiefungen an der Außenfläche der Diamantsäulenstruktur zu hinterlassen.

Es können sowohl die Keimbedingungen als auch die bevorzugten Prozessparameter für die einzelnen Phasen des Kristallwachstums während der chemischen Gasphasenabscheidung eingestellt und kontrolliert werden:
Die Größe der Kristallite wird beispielsweise durch den Abstand der Keime am Substrat, der sich reziprok zur Keimdichte verhält, bestimmt, wenn gleichzeitig die auftreffenden Reaktionspartner ausreichende freie Weglänge haben, die über die Substrattemperatur beeinflusst werden kann.

Tiefe Zwischenräume an der Innenseite verbleiben besonders, wenn das Wachstum senkrecht zur Substratoberfläche wesentlich schneller erfolgt als das Wachstum parallel zur Substratoberfläche (Breitenwachstum).

Schließlich kann man bevorzugte Facetten gezielt vergrößern, indem man das Wachstum gerade in Richtung der konkurrierenden Facetten fördert.

Beispiele für Diamantsäulentexturen und erfindungsgemäße Konverter sowie das Kristallwachstum sind weiter unten und in den beiliegenden Figuren eingehend beschrieben.

Vorzugswiese weisen die Diamantsäulenkristalle eine mittlere Breite (mittlere Kristallitbreite) von 1 bis 500 µm, vorzugsweise eine Breite von 20 bis 100 µm, auf. Bei diesen Größen entstehen bei der Lichtkonversion Pixel. Geringere mittlere Breiten sind durch die Ausdehnung der derzeit eingesetzten Laserspots weniger bevorzugt, könnten jedoch bei entsprechender Weiterentwicklung der Laser ebenfalls zielführend eingesetzt werden. Umgekehrt verringern größere Breiten die statistische Mischung von durchtretendem Primär- und gestreutem Sekundärlicht aufgrund der (begrenzten) Anregungsfläche des Laserspots.

Bei vorteilhaften Ausführungsformen sind Zwischenräume der flächigen Diamantträgerstruktur zumindest teilweise mit dem Konvertermaterial gefüllt. "Gefüllt" bedeutet, dass das Konvertermaterial den Zwischenraum teilweise oder gänzlich füllt oder als Schicht auf den Zwischenraumoberflächen aufgebracht ist.

Der Begriff "Zwischenraum" bezieht sich insbesondere auf Täler in der Oberflächentopografie der flächigen Diamantträgerstruktur.

Ferner können bei bestimmten Ausführungsformen mittels gezieltem Diamantwachstum und abwechselndem Abscheiden von polykristallinem Diamant und Konvertermaterial mit Konvertermaterial befüllte geschlossene Zwischenräume in der Diamantträgerstruktur erzeugt werden. Beispielsweise können offene Zwischenräume oder Täler in der Diamantträgerstruktur mit dem Konvertermaterial befüllt und das Konvertermaterial durch Fortsetzung der CVD-Diamantabscheidung in der Diamantträgerstruktur eingeschlossen werden.

Bei weiteren Varianten, die weiter unten im Detail beschrieben ist, kann zuerst das Konvertermaterial strukturiert auf einem Substrat aufgebracht werden und anschließend lässt man in den Bereichen zwischen den Konvertermaterialstrukturen die Diamantsäulen wachsen, die in weiterer Folge zu einer polykristallinen flächigen Diamantsäulentextur zusammenwachsen.

Für Scheinwerferanwendungen ist es von Vorteil, wenn die mit Konvertermaterial gefüllten Zwischenräume (d.h. die Schichtdicke des Konvertermaterials) eine Dicke von 10 µm bis 2 mm, vorzugsweise eine Dicke von 100 bis 500 µm, aufweisen.

Die flächige Diamantträgerstruktur weist eine Innenfläche und eine Außenfläche auf, die wie oben beschrieben topografisches Strukturen besitzen. Bei bestimmten Ausführungsformen sind die Zwischenräume/Täler auf zumindest einer der beiden Flächen der Diamantträgerstruktur zumindest teilweise mit Konvertermaterial gefüllt.

Vorzugsweise sind zumindest die Zwischenräume/Täler auf der Innenfläche der Diamantträgerstruktur zumindest teilweise mit Konvertermaterial gefüllt. Die Innenfläche ist deshalb die bevorzugte Seite, weil hier aufgrund des Kristallwachstums die Zwischenräume/Täler tiefer sind und eine größere Dicke des eingefüllten Konvertermaterials erlauben. Um die Zwischenräume auf der Innenfläche der Diamantträgerstruktur mit Konvertermaterial befüllen zu können, muss die Diamantträgerstruktur vom Substrat (bzw. das Substrat von der Diamantträgerstruktur) gelöst werden, was weiter unten beschrieben wird.

Bei weiteren Ausführungsformen können die Zwischenräume/Täler auf beiden Flächen der flächigen Diamantträgerstruktur zumindest teilweise mit Konvertermaterial gefüllt sein.

Die flächige Diamantträgerstruktur weist eine Innenfläche und eine Außenfläche auf, die wie oben beschrieben topografisches Strukturen besitzen. Bei anderen Ausführungsformen ist das Konvertermaterial auf Erhebungen auf zumindest einer der beiden Flächen der Diamantträgerstruktur zumindest teilweise aufgebracht.

Bei bestimmten Untervarianten ist das Konvertermaterial auf Erhebungen auf der Außenseite der Diamantträgerstruktur zumindest teilweise aufgebracht.

Das Konvertermaterial ist vorzugsweise aus der Gruppe bestehend aus Cer-dotiertem Yttrium Aluminium Granat (YAG-Ce), Lanthan dotiertem Yttriumoxid (V₂O₃-La₂O₃), Magnesium Aluminium Spinell (MgAl₂O₄) und Europium-dotiertem M₂Si₅N₈ mit M = Ca, Sr oder Ba ausgewählt.

Ein weiterer Gegenstand der Erfindung betrifft eine Leuchtvorrichtung für einen Kraftfahrzeugscheinwerfer bzw. eine Signalleuchte, umfassend eine Primärlichtquelle und einen erfindungsgemäßen Konverter (Lichtkonverter) wie er hierin geoffenbart ist. Bei der Primärlichtquelle handelt es sich für Scheinwerferanwendungen mit Vorteil um eine Laserlichtquelle, vorzugsweise eine Laserlichtquelle, die blaues Licht emittiert.

Ein weiterer Gegenstand der Erfindung betrifft ferner einen Kraftfahrzeugscheinwerfer bzw. eine Signalleuchte umfassend einen erfindungsgemäßen Konverter oder eine erfindungsgemäße Leuchtvorrichtung wie hierin geoffenbart. Der Begriff "Kraftfahrzeugscheinwerfer" bzw. "Scheinwerfer" umfasst alle Arten von Kraftfahrzeugscheinwerfern, insbesondere Frontscheinwerfer, der Begriff "Signalleuchten" umfasst alle Arten von Signalleuchten, einschließlich Heckleuchten.

Ferner betrifft die Erfindung ein erstes vorteilhaftes Verfahren zum Herstellen eines erfindungsgemäßen Konverters für eine Leuchtvorrichtung wie hierin beschrieben, gekennzeichnet durch die folgenden Schritte:
a) Herstellen einer flächigen polykristallinen Diamantträgerstruktur auf einem flächigen Substrat mittels chemischer Abscheidung aus der Gasphase (Chemical Vapor Deposition, CVD),
b)zumindest teilweises Aufbringen von Konvertermaterial in Bereichen der Diamantträgerstruktur, wobei zwischen den das Konvertermaterial aufweisenden Bereichen Freiräume verbleiben, die einen konversionsfreien Durchtritt des Primärlichts durch die Diamantträgerstruktur ermöglichen, und
gegebenenfalls Lösen des flächigen Substrats von der polykristallinen Diamantträgerstruktur nach dem Schritt a) oder nach dem Schritt b).

Die Herstellung polykristalliner CVD-Diamantstrukturen ist an sich bekannt und in der Literatur ausführlich beschrieben (siehe z.B. Hartmann P., 1997, Dissertation TU Wien: Diamantabscheidung mit der DC-Glimmentladungsmethode sowie mit Bor- und Stickstoff-Zugabe im Hot-Filament-Verfahren; Wild et al., 1993, Diamond and Related Materials 2:158-168). Zur Reaktion muss atomarer Wasserstoff und aktivierter Kohlenwasserstoff zur Verfügung gestellt werden, was beispielsweise durch thermische Dissoziation, Glimmentladung oder Plasma, welches durch Mikrowellen angeregt wird, erreicht wird. Als Kohlenstoffquellen werden in gängiger Praxis häufig Methan und/oder Acetylen eingesetzt. Polykristalline Diamantstrukturen entstehen typischerweise bei Temperaturen zwischen ca. 750 bis ca. 950°C, einem hohen Angebot an atomaren Wasserstoff und einem niedrigen Angebot an Kohlenstoff. Die Temperatur des Substrats von über 750°C sorgt für eine ausreichende mittlere freie Weglänge der Reaktionspartner auf dem Substrat, so dass sich Kristallite in geeigneter Größe ergeben; unterhalb dieser Temperatur erzielt man eine sehr feine Körnung und schließlich Graphit. Zusätzlich wird im Temperaturbereich von ca. 750°C bis ca. 950°C die Abspaltung von Wasserstoff von der Oberfläche der Kristallite ermöglicht, wodurch die Reaktion an der Oberfläche aufrechterhalten wird.

Die das Konvertermaterial aufweisenden Bereiche sind aus der Gruppe bestehend aus Zwischenräumen (Täler, geschlossene Zwischenräume wie oben beschrieben) und Erhebungen der Diamantträgerstruktur ausgewählt.

Um die in Schritt a) erhaltenen polykristalline Diamantträgerstruktur auch von der Innenfläche (d.h. von jener Seite, die dem Substrat zugewandt ist) befüllen zu können, müssen die Diamantträgerstruktur und das Substrat voneinander getrennt werden. Die Methoden unterscheiden sich je nach Substrat. Im Fall dauernder Haftung (beispielsweise bei chemischer Bindung) muss das Substrat durch Ätzen entfernt werden, Silizium als Substrat kann beispielweise oxidierend in einem Flusssäure-Salpetersäure-Gemisch aufgelöst werden. Im Fall eines Molybdänsubstrats ist die Diamantträgerstruktur nur schwach gebunden und löst sich während des Abkühlens aufgrund der unterschiedlichen thermischen Ausdehnungskoeffizienten von der Molybdänsubstratoberfläche ab.

Bei bestimmten Ausführungsformen kann die Diamantträgerstruktur vor dem Aufbringen des Konvertermaterials durch ein Focussed Ion Beam (FIB)-Verfahren, durch Laser-Bohren, durch oxidatives Ätzen (z.B. durch Aufbringen einer Metallschicht auf einzelne Kristallkörner und anschließendes oxidatives Rückätzen der Bereiche zwischen den metallbeschichteten Körnern), durch Aufbringen eines heißen Metallpulvers (beispielsweise pulverförmigem Cer oder Fe), durch Polieren oder durch Prägen (z.B. mit einem heißen Eisenwerkzeug) bearbeitet werden. Unter Prägen wird hier kein Materialverdrängen verstanden, sondern Lösen von Kohlenstoff aus der Diamantstruktur im metallischen Prägewerkzeug. Auf diese Weise können weitere Strukturen in die Diamantträgerstruktur eingebracht oder Strukturen wie z.B. Diamantsäulenkristallspitzen abgetragen werden.

Bei einer Weiterbildung des Verfahrens kann zum Verbessern der Haftung des Konvertermaterials auf der Diamantträgerstruktur, zumindest bereichsweise vor dem Aufbringen des Konvertermaterials eine (metallische, oxidische, carbidische, nitridische) Haftschicht auf der Diamantträgerstruktur aufgebracht werden.

Das Konvertermaterial kann durch eine Reaktion in situ, beispielsweise durch chemische Abscheidung gasförmiger Reaktanten, auf die Diamantträgerstruktur aufgebracht werden. Das hat den Vorteil, dass der Prozess im gleichen Reaktor wie jenem zur Erzeugung der Diamantträgerstruktur durchgeführt werden kann. Ebenso kann das Konvertermaterial durch (physikalische) Materialabscheidung/Kondensation auf die Diamantträgerstruktur aufgebracht werden, wobei das Konvertermaterial ohne Änderung der Zusammensetzung, beispielsweise durch Sputtern oder Spraycoaten, von einer Materialquelle auf die Diamantträgerstruktur transferiert wird.

Alternativ dazu kann das Konvertermaterial in einer festen, flüssigen oder gelförmigen Vorform aufgebracht und in einer nachfolgenden Reaktion, beispielsweise durch ein Temperaturprofil gesteuert, in eine feste Phase, die mit der Diamantträgerstruktur verbunden ist, umgewandelt werden. Vorteilhaft ist dabei, dass die dazu erforderliche Temperatur niedriger als bei chemischer Abscheidung ist, so dass die Diamantträgerstruktur auch unter beispielsweise oxidierenden Bedingungen nicht angegriffen wird. Unter solche Verfahren fallen beispielsweise Sol-Gel-Verfahren, unter die einzelnen Verfahrensschritte Aufrakeln und Sintern.

Durch Maskierung/Ätzen von bevorzugt metallischen oder photopolymeren Hilfsschichten kann zudem die Aufbringung des Konvertermaterials lokal gesteuert werden.

Ein weiteres vorteilhaftes Verfahren zum Herstellen eines erfindungsgemäßen Konverters für eine Leuchtvorrichtung wie hierin beschrieben, ist durch die folgenden Schritte gekennzeichnet:
a) Herstellen einer strukturierten Konvertermaterialschicht auf einem flächigen Substrat,
b) Abscheiden einer flächigen polykristallinen Diamantträgerstruktur auf dem die strukturierte Konvertermaterialschicht aufweisenden Substrat mittels chemischer Abscheidung aus der Gasphase (Chemical Vapor Deposition, CVD), und
gegebenenfalls Lösen des flächigen Substrats von der polykristallinen, das Konvertermaterial aufweisenden Diamantträgerstruktur nach dem Schritt b).

Bei diesem Verfahren wird also zuerst das Konvertermaterial strukturiert auf einem Substrat aufgebracht und anschließend lässt man in den Bereichen zwischen den Konvertermaterialstrukturen die Diamantsäulen wachsen, die in weiterer Folge zu einer polykristallinen flächigen Diamantsäulentextur zusammenwachsen. Die polykristalline, mit Konvertermaterial gefüllte Diamantträgerstruktur kann anschließend, falls erwünscht, von dem Substrat getrennt werden. Die Herstellung polykristalliner CVD-Diamantstrukturen erfolgt wie oben im Zusammenhang mit dem ersten Verfahren beschrieben. Das Konvertermaterial kann bei diesem Verfahren chemisch aus der Gasphase (Chemical Vapor Deposition, CVD) oder physikalisch durch Materialabscheidung/Kondensation (Physical Vapor Deposition, PVD) auf fotolithographisch strukturierbaren Hilfsschichten, beispielsweise Lack, abgeschieden werden oder nach ganzflächiger Abscheidung fotolithographisch strukturiert werden. In anderen Verfahren können feste oder gel-förmige Vorformen strukturiert aufgebracht, z.B. strukturiert aufgedruckt, werden, indem sie beispielsweise durch Masken geprintet werden. Die nachfolgende Umwandlung der Vorform in das Konvertermaterial kann wiederum durch ein Temperaturprofil gesteuert werden, bevorzugt könnte aber auch das Temperaturbudget der nachfolgenden Diamantstrukturerzeugung (oben Schritt b)), nämlich deren Temperatur über die gegebene Prozesszeit, genutzt werden.

Bei einer Variante der oben beschriebenen erfindungsgemäßen Verfahren beruht die chemische Abscheidung der Diamantträgerstruktur aus der Gasphase auf einer gezielten Keimung der Diamantkristalle auf dem Substrat, wobei das Substrat oder die Substratoberfläche aus einem Fremdmaterial gefertigt ist. Unter dem Begriff "Fremdmaterial" ist ein Material zu verstehen, das nicht aus Diamant besteht. Vorzugsweise ist das Substrat aus der Gruppe bestehend aus Silizium, einem Element aus der Gruppe der Refraktärmetalle (Ti, Zr, Hf, Va, Nb, Ta, Cr, Mo und W), insbesondere Molybdän, Carbiden von Silizium, Carbiden von einem Element aus der Gruppe der Refraktärmetalle (Ti, Zr, Hf, Va, Nb, Ta, Cr, Mo und W), Silizium mit carbidisierter Oberfläche und einem Element aus der Gruppe der Refraktärmetalle (Ti, Zr, Hf, Va, Nb, Ta, Cr, Mo und W) mit carbidisierter Oberfläche gefertigt. Auf Fremdmaterial beginnt das Kristallwachstum an den Keimstellen.

Bei einer weiteren Variante der erfindungsgemäßen Verfahren erfolgt die chemische Abscheidung aus der Gasphase in Schritt a) auf Grundlage eines Homoepitaxieprozesses. Als Substrat kommt dabei ein Diamantsubstrat in Frage, welches insbesondere aus HPHT-Diamant (z.B. Sumicrystal™ der Firma Sumimoto Electric USA oder Diamantsubstrate der Firma Element Six), und, vorzugsweise polierten, Natur- oder CVD-Diamantsubstraten ausgewählt ist. Bei einem Diamantsubstrat dient die gesamte zur Verfügung stehende Oberfläche als Keimfläche. In Bereichen, die Zwischenräume für das Konvertermaterial frei halten sollen, wird die Oberfläche mit strukturierten Materialien bedeckt. Als Materialien dafür können z.B. Metalle wie Cu, Au oder Ag, die eine geringe Löslichkeit für Kohlenstoff haben und keine Carbide ausbilden, eingesetzt werden. Die Materialien können z.B. zunächst ganzflächig auf der Substratoberfläche aufgebracht werden und photolithographisch zu keimfreien Inseln strukturiert werden. Alternativ dazu kann anstelle eines Strukturmaterials das Konvertermaterial als strukturierte Schicht,, vor dem Abscheiden der Diamantträgerstruktur auf dem Diamantsubtrat aufgebracht werden (siehe obige Beschreibung in Verbindung mit dem alternativen Verfahren).

Das Konvertermaterial ist mit Vorteil aus der Gruppe bestehend aus Cer-dotiertem YAG (Yttrium Aluminium Granat, Lanthan dotiertem Yttriumoxid (Y₂O₃-La₂O₃), Magnesium Aluminium Spinell (MgAl₂O₄) und Europium-dotiertem M₂Si₅N₈ mit M = Ca, Sr oder Ba ausgewählt.

Die Erfindung wird im Folgenden anhand von nicht einschränkenden Beispielen und den beiliegenden Zeichnungen näher beschrieben.
Fig. 1 zeigt ein Beispiel für den Aufbau eines Reaktors 1 für die chemische Abscheidung aus der Gasphase (CVD-Reaktor), der für die Herstellung eines erfindungsgemäßen Lichtkonverters zur Anwendung kommen kann.
Fig. 2 zeigt ein Kohlenstoff-Phasendiagramm, das den Einfluss der wichtigsten Wachstumsparameter auf die Kristallmorphologie von Diamant darstellt.
Fig. 3 zeigt eine schematische Darstellung einer polykristallinen Diamantträgerstruktur in einem Schnitt senkrecht zur Substratoberfläche, in welcher die Wachstumsphasen von Diamantsäulenkristallen veranschaulicht sind.
Fig. 4 a - f zeigen den Zusammenhang zwischen der Ausbildung von Facetten und Wachstumsgeschwindigkeit in bestimmten Richtungen.
Fig. 5 a - j zeigen verschiedene Ausführungsformen von Konvertern gemäß der Erfindung.

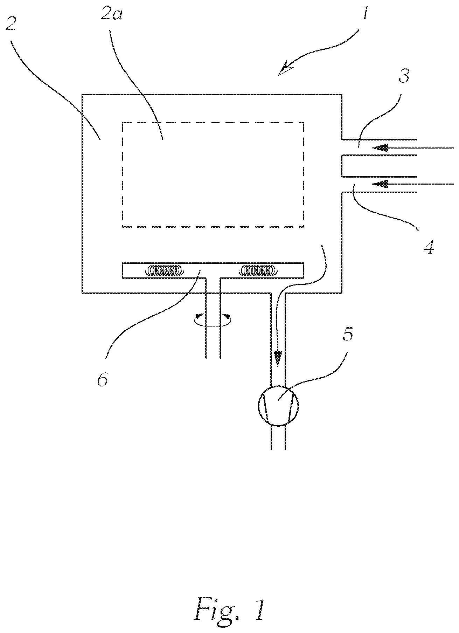

Fig. 1 zeigt ein Beispiel für einen weit verbreiteten CVD-Reaktor 1, der für die Herstellung einer flächigen Diamantträgerstruktur für einen erfindungsgemäßen Lichtkonverter zur Anwendung kommen kann. Der CVD-Reaktor 1 verfügt über einen Innenraum 2, der zum Herstellen eines Vakuums mittels einer Pumpe 5 evakuierbar ist (Basisdruck < 1mbar, dabei geringer N₂-Partialdruck; Prozessdruck zwischen 1 mbar und 1 bar (je nach Soll-Abscheiderate, Leistung, Gasfluss), wobei bevorzugt hochreine Prozessgase zum Einsatz kommen). Der CVD-Reaktor 1 verfügt über Gaseinlässe 3, 4 in den Innenraum 2, über welche Prozessgase wie molekularer Wasserstoff bzw. gasförmige Kohlenwasserstoffverbindungen und/oder Trägergase in den Innenraum 2 eingebracht werden. Zur reaktiven Abscheidung muss in einem Bereich des Innenraums 2, dem Reaktionsraum 2a, atomarer Wasserstoff und aktivierter Kohlenwasserstoff zur Verfügung gestellt werden, was beispielsweise durch thermische Dissoziation, Glimmentladung oder Plasma, welches durch Mikrowellen angeregt wird, erreicht wird. Als Kohlenstoffquellen werden in gängiger Praxis häufig Methan und/oder Acetylen eingesetzt. Ferner verfügt der Reaktor 1 über eine beheizbare Ablage 6 für Substrate, auf welchen die flächige Diamantträgerstruktur und bei bestimmten Anwendungen auch das Konvertermaterial mittels CVD abgeschieden werden.

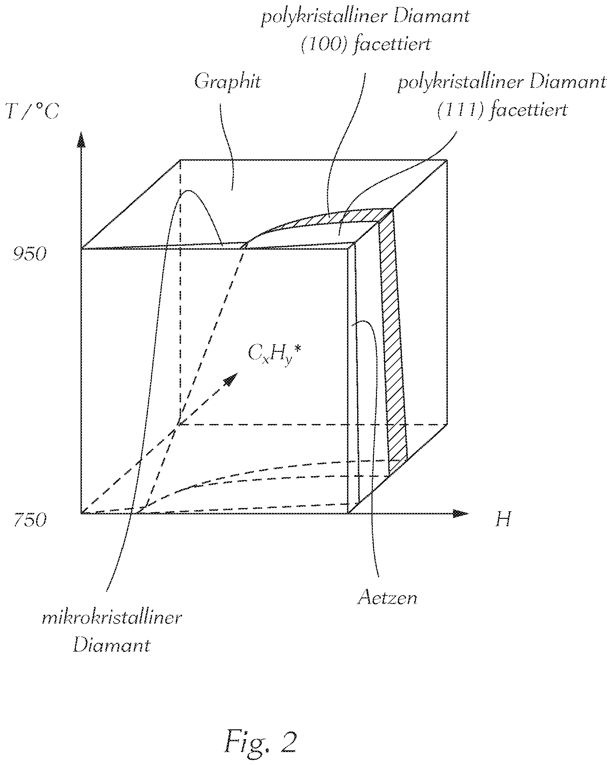

Fig. 2 zeigt ein Kohlenstoff-Phasendiagramm, das den Einfluss der wichtigsten Wachstumsparameter auf die Kristallmorphologie darstellt (in abgewandelter Form entnommen aus L. Vandenbulcke et al. 7. Euro-CVD Conference, Perpignan, Frankreich, 19-23 Juni 1989). Wie aus dem Phasendiagramm ersichtlich ist, entstehen polykristalline Diamantstrukturen ((100) facettiert und (111) facettiert) bei Temperaturen zwischen ca. 750 bis ca. 950°C, einem hohen Angebot an atomaren Wasserstoff (H) und einem niedrigen Angebot an aktivierten Kohlenwasserstoffverbindungen (CₓH_{y}* wie z.B. Methan CH₄, oder Acetylen C₂H₂). Die Temperatur des Substrats von über 750°C sorgt für eine ausreichende mittlere freie Weglänge der Reaktionspartner auf dem Substrat, so dass sich Kristallite in geeigneter Größe ergeben; unterhalb dieser Temperatur erzielt man keine kristalline Kohlenstoff-Modifikation.

Fig. 3 zeigt eine schematische Darstellung einer polykristallinen Diamantträgerstruktur 10, in welcher die Wachstumsphasen A, B und C von Diamantsäulenkristallen 13, 13, 13 auf einer Substratoberfläche 11 im Laufe eines CVD-Abscheideverfahrens veranschaulicht sind.
- Wachstumsphase A: beginnend mit geringer Keimdichte erfolgt ein schnelles Wachstum der Kristallite nach oben, d.h. im Wesentlichen senkrecht zur Substratoberfläche 11, sodass ausreichend Zwischenräume 12 zwischen den einzelnen Diamantsäulenkristallen 13, 13, 13 auf der Innenfläche 10a (d.h. jener Seite, die der Substratoberfläche 11 zugewandt ist) der Diamantträgerstruktur 10 bleiben.
- Wachstumsphase B: nach dem Zusammenwachsen der einzelnen Diamantsäulenkristalle 13, 13, 13 wird Schichtdicke und thermische Masse unter Erhalt einer polykristallinen Diamantsäulentextur erzeugt.
- Wachstumsphase C: die Ausbildung bevorzugter Facetten an der Außenfläche 10b der Diamantträgerstruktur 10. Beispielsweise würden (111) Facetten ohne weitere Nachbearbeitung genügend Zwischenräume 12 für die Aufnahme von Konvertermaterial auf der Außenfläche 10b der Diamantträgerstruktur 10 ausbilden.

Bei bestimmten Ausführungsformen kann die Diamantträgerstruktur 10 vor dem Aufbringen des Konvertermaterials durch ein Focussed Ion Beam (FIB)-Verfahren, durch oxidatives Ätzen (z.B. durch Aufbringen einer Metallschicht auf einzelne Kristallkörner und anschließendes oxidatives Rückätzen der Bereiche zwischen den metallbeschichteten Körnern), durch Polieren oder durch Prägen (z.B. mit einem heißen Eisenwerkzeug) bearbeitet werden. Auf diese Weise können weitere Strukturen in die Diamantträgerstruktur 10 eingebracht oder Strukturen wie z.B. Diamantsäulenkristallspitzen abgetragen werden.

Um auch auf der Innenfläche 10a der polykristallinen Diamantträgerstruktur 10 Konvertermaterial aufbringen zu können, müssen die Diamantträgerstruktur 10 und das Substrat 11 voneinander getrennt werden. Die Methoden unterscheiden sich je nach eingesetztem Substrat. Im Fall eines Siliziumsubstrats kann das Substrat durch Ätzen oder durch oxidierendes Auflösen in einem Flusssäure-Salpetersäure-Gemisch von der Diamantträgerstruktur 10 entfernt werden. Im Fall eines Molybdänsubstrats ist die Diamantträgerstruktur 10 nur schwach gebunden und löst sich während des Abkühlens aufgrund der unterschiedlichen thermischen Ausdehnungskoeffizienten von der Molybdänsubstratoberfläche ab.

Zum Verbessern der Haftung des Konvertermaterials auf der Diamantträgerstruktur 10 kann außerdem vor dem Aufbringen des Konvertermaterials zumindest bereichsweise eine (metallische, oxidische, carbidische, nitridische) Haftschicht auf der Diamantträgerstruktur 10 aufgebracht werden.

Das Konvertermaterial kann insbesondere aus der Gruppe bestehend aus Cer-dotiertem YAG (Yttrium Aluminium Granat, Lanthan dotiertem Yttriumoxid (Y₂O₃-La₂O₃), Magnesium Aluminium Spinell (MgAl₂O₄) und Europium-dotiertem M₂Si₅N₈ mit M = Ca, Sr oder Ba ausgewählt sein.

Das Konvertermaterial kann durch chemische Abscheidung gasförmiger Reaktanten oder (physikalische) Materialabscheidung/Kondensation (z.B. Sputtern oder Spraycoaten) in den Zwischenräumen 12 der Diamantträgerstruktur 10 eingebracht bzw. auf deren Erhebungen aufgebracht werden. Alternativ dazu kann das Konvertermaterial in einer festen, flüssigen oder gelförmigen Vorform auf die Diamantträgerstruktur aufgebracht werden (z.B. durch Aufrakeln oder mittels Sol-Gel-Verfahren) und in einer nachfolgenden Reaktion (z.B. durch Sintern) in eine feste Phase umgewandelt werden.

Durch Maskierung/Ätzen von bevorzugt metallischen oder photopolymeren Hilfsschichten kann zudem die Aufbringung des Konvertermaterials lokal gesteuert werden.

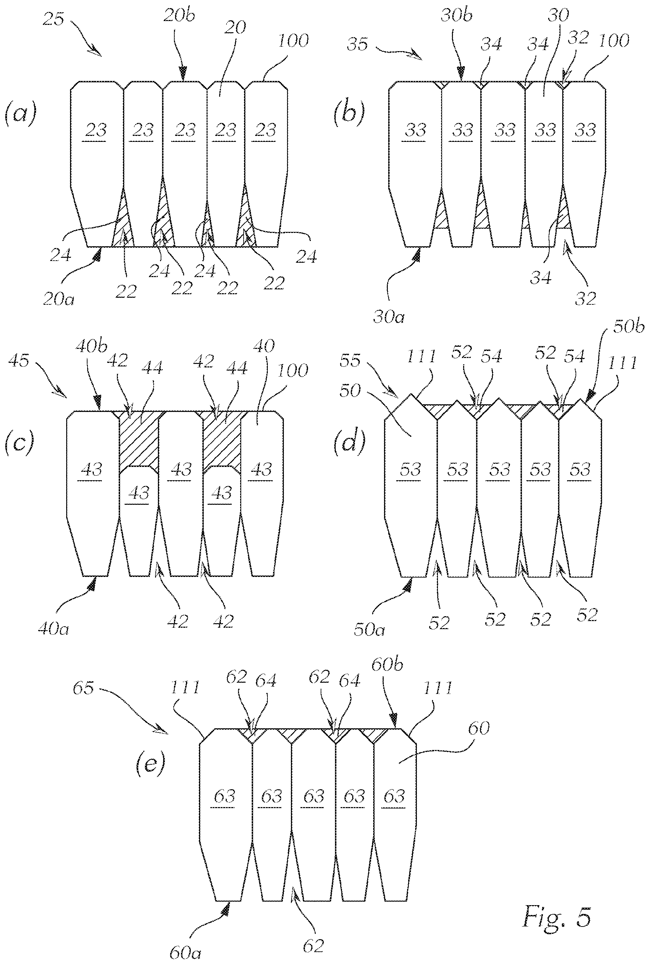

Beispiele für verschiedene Konverterausführungen sind weiter unten im Zusammenhang mit den Fig. 5a - j beschrieben.

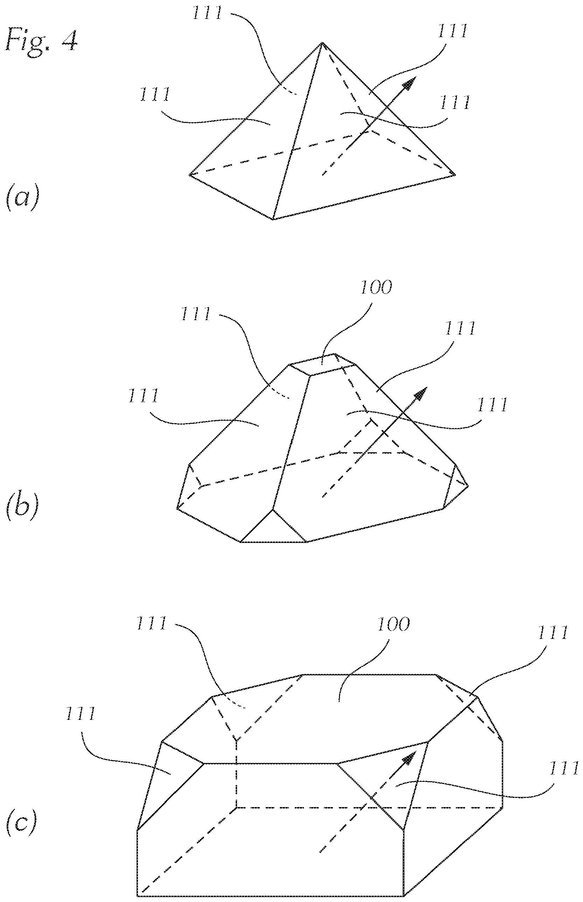

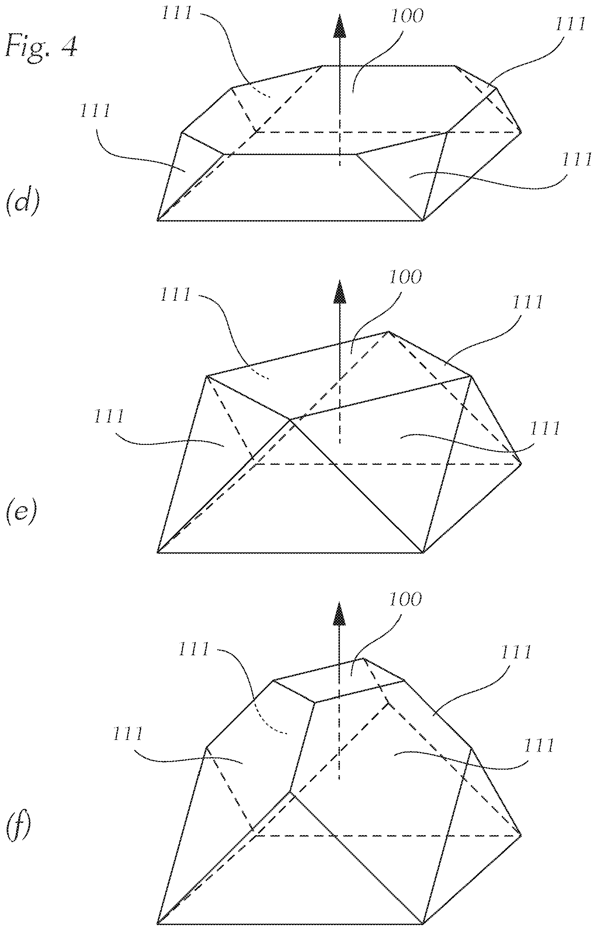

Fig. 4 a - f zeigen den Zusammenhang zwischen der Ausbildung von Facetten und der Wachstumsgeschwindigkeit von Diamantkristallen in bestimmten Richtungen. Ausgehend von tetraedischen (111) Facetten (Fig. 4a) soll ein bevorzugtes Wachstum (durch den Pfeil gekennzeichnet) in (111) Richtung, der Flächennormalen der Tetraederflächen, erfolgen. Die (111) Facetten sind mit 111 gekennzeichnet. Durch das Wachstum in (111) Richtung entsteht zunächst eine (100) Facette (Fig. 4b). Die (100) Facette ist mit 100 gekennzeichnet. Wählt man Bedingungen, unter denen das Wachstum in (100) Richtung langsam im Vergleich zur (111) Richtung ist, verschwinden die ursprünglichen (111) Facetten zugunsten der (100) Facette (Fig. 4c).

In umgekehrter Weise kann die Oberfläche gezielt mit (111) Facetten abgeschlossen werden. Ausgehend von einer Oberfläche, an der (100) und (111) Facetten gemischt vorliegen (Fig. 4d), wählt man Wachstumsbedingungen, die Wachstum in der (100) Richtung (durch Pfeile gekennzeichnet) bevorzugen und Wachstum in (111) Richtung unterdrücken. Dadurch gewinnen die (111) Facetten an Ausdehnung, während die (100) Facetten an Ausdehnung verlieren (Fig. 4e und 4f). Auf diese Weise kann man die Facetten an der Oberfläche, der Außenseite, der Diamantträgerstruktur einstellen und die Topographie der Außenseite gestalten. Eine Aneinanderreihung von Kristalliten, die mit Oberflächen wie in Fig. 4f abgeschlossen sind, erzeugt eine Topographie mit tiefen Zwischenräumen zwischen den Erhebungen.

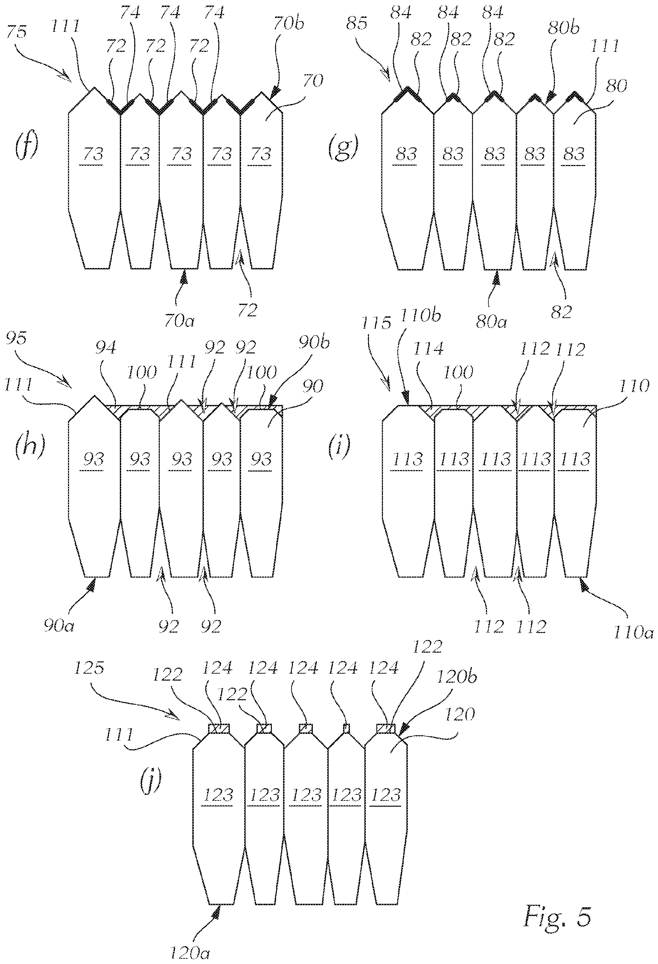

Fig. 5 a - j zeigen verschiedene Ausführungsformen von Konvertern gemäß der Erfindung.

Fig. 5a zeigt einen Konverter 25 mit einer polykristallinen Diamantträgerstruktur 20, die aus einer Vielzahl an Diamantsäulenkristallen 23 zusammengesetzt ist. Die Diamantträgerstruktur besitzt eine Innenfläche 20a und eine Außenfläche 20b, wobei die talförmigen Zwischenräume 22 auf der Innenfläche 20a mit einem Konvertermaterial 24 gefüllt sind. Das Konvertermaterial 24 hat die Aufgabe, das Licht einer Wellenlänge, wie z.B. blaues Laser-Licht, in Licht einer anderen Wellenlänge oder eines Wellenlängengemisches, insbesondere in "weißes" Licht, umzuwandeln. Auf der Außenfläche 20b sind durch kontrolliertes Kristallwachstum im CVD-Verfahren (100) Facetten ausgebildet.

Fig. 5b zeigt einen Konverter 35 mit einer polykristallinen Diamantträgerstruktur 30, die aus einer Vielzahl an Diamantsäulenkristallen 33 zusammengesetzt ist. Die Diamantträgerstruktur 30 entspricht der Diamantträgerstruktur 20 aus Fig. 5a, mit dem Unterschied, dass die talförmigen Zwischenräume 32 der Diamantträgerstruktur 30 beidseitig, d.h. sowohl auf der Innenfläche 30a als auch auf der Außenfläche 30b, mit Konvertermaterial 34 (teilweise) befüllt sind. Auf der Außenfläche 30b sind durch kontrolliertes Kristallwachstum im CVD-Verfahren (100) Facetten ausgebildet.

Fig. 5c zeigt einen Konverter 45 mit einer polykristallinen Diamantträgerstruktur 40, die aus einer Vielzahl an Diamantsäulenkristallen 43 zusammengesetzt ist. Die Diamantträgerstruktur 40 besitzt eine Innenfläche 40a und eine Außenfläche 40b, wobei die talförmigen Zwischenräume 42 auf der Außenfläche 40b mit einem Konvertermaterial 44 aufgefüllt sind. Die talförmigen Zwischenräume 42 auf der Innenfläche 40a sind nicht gefüllt. Die Außenfläche 40b der Diamantträgerstruktur 40 wurde vor dem Befüllen mit Konvertermaterial 44 durch Maskieren und ein Focussed Ion Beam (FIB)-Verfahren weiter strukturiert, um auf der Außenfläche 40b größere Zwischenräume 42 für die Aufnahme des Konvertermaterials 44 zu schaffen. Auf der Außenfläche 40b sind durch kontrolliertes Kristallwachstum im CVD-Verfahren (100) Facetten ausgebildet.

Fig. 5d zeigt einen Konverter 55 mit einer polykristallinen Diamantträgerstruktur 50, die aus einer Vielzahl an Diamantsäulenkristallen 53 zusammengesetzt ist. Die Diamantträgerstruktur 50 besitzt eine Innenfläche 50a und eine Außenfläche 50b, wobei die talförmigen Zwischenräume 52 auf der Außenfläche 50b mit einem Konvertermaterial 54 befüllt sind. Die Zwischenräume 52 auf der Innenfläche 50a sind ungefüllt. Auf der Außenfläche 50b sind durch kontrolliertes Kristallwachstum im CVD-Verfahren (111) Facetten ausgebildet, so dass die einzelnen Diamantsäulenkristalle 53 an der Außenfläche 50b spitz zulaufen.

Fig. 5e zeigt einen Konverter 65 mit einer polykristallinen Diamantträgerstruktur 60, die aus einer Vielzahl an Diamantsäulenkristallen 63 zusammengesetzt ist. Die Diamantträgerstruktur 60 besitzt eine Innenfläche 60a und eine Außenfläche 60b, wobei die talförmigen Zwischenräume 62 auf der Außenfläche 60b mit einem Konvertermaterial 64 befüllt sind. Die Zwischenräume 62 auf der Innenfläche 60a sind ungefüllt. Auf der Außenfläche 60b wurden durch kontrolliertes Kristallwachstum im CVD-Verfahren (111) Facetten ausgebildet, so dass die einzelnen Diamantsäulenkristalle 63 zuerst eine Spitze an der Außenfläche 60b aufwiesen (siehe Fig. 5d), die anschließend gekappt wurden (z.B. durch Ätzen, Polieren oder mittels Focussed Ion Beam (FIB)-Verfahren).

Fig. 5f bzw. Fig. 5g zeigen Konverter 75 bzw. 85 mit einer polykristallinen Diamantträgerstruktur 70 bzw. 80, die aus einer Vielzahl an Diamantsäulenkristallen 73 bzw. 83 zusammengesetzt ist. Die Diamantträgerstruktur 70 bzw. 80 besitzt eine Innenfläche 70a bzw. 80a und eine Außenfläche 70b bzw. 80b. Auf der Außenfläche 70b bzw. 80b sind durch kontrolliertes Kristallwachstum im CVD-Verfahren (111) Facetten ausgebildet, so dass die einzelnen Diamantsäulenkristalle 73 bzw. 83 an der Außenfläche 70b bzw. 80b eine Spitze ausbilden. Die Außenfläche 70b bzw. 80b ist strukturiert mit Konvertermaterial 74 bzw. 84 bedeckt.

Beim Konverter 75 (Fig. 5f) sind die talförmigen Zwischenräume 72 auf der Außenfläche 70b mit Konvertermaterial 74 ausgekleidet. Für das Auskleiden kommt beispielsweise eine konforme Abscheidung durch einen diffusionskontrollierten CVD-Prozess zum Einsatz. Ein (nachfolgender oder konkurrierender) physikalischer Ätzprozess würde den Konverter bevorzugt an den Spitzen der Außenfläche 70b abtragen, so dass diese frei von Konvertermaterial sind. Ein physikalischer Ätzprozess beruht auf Abtrag unter Ionenbeschuss und erreicht an topographischen Spitzen aufgrund der lokal höheren Spannung höhere Abtragungsraten.

Beim Konverter 85 (Fig. 5g) sind nur die Spitzen 82 auf der Außenfläche 80b mit Konvertermaterial 84 beschichtet. Hierbei kommen beispielsweise fotolithographische Verfahren in Betracht. Dabei wird beispielsweise Fotolack als Hilfsschicht aufgeschleudert und die Spitzen werden durch Belichten und Entwickeln freigestellt. Anschließend wird das Konvertermaterial aufgebracht und nachfolgend Hilfsschicht und Konvertermaterial aus den Tälern zwischen den Spitzen entfernt. Das Entfernen der lithographischen Hilfsschicht geschieht dabei in einem eigenen Prozessschritt oder unter Ausnutzen der erhöhten Temperatur eines Folgeprozesses.

Fig. 5h zeigt einen Konverter 95 mit einer polykristallinen Diamantträgerstruktur 90, die aus einer Vielzahl an Diamantsäulenkristallen 93 zusammengesetzt ist. Die Diamantträgerstruktur 90 besitzt eine Innenfläche 90a und eine Außenfläche 90b, wobei die talförmigen Zwischenräume 92 auf der Außenfläche 90b mit einem Konvertermaterial 94 befüllt sind. Die Zwischenräume 92 auf der Innenfläche 90a sind ungefüllt. Auf der Außenfläche 90b ist durch kontrolliertes Kristallwachstum im CVD-Verfahren eine gemischt facettierte Säulentexturierung, die sowohl (111) Facetten als auch (100) Facetten umfasst, ausgebildet.

Fig. 5i zeigt einen Konverter 115, der sich von dem Konverter 95 nur dadurch unterscheidet, dass die Spitzen der Diamantsäulenkristalle 113 an der Außenfläche 110b der Diamantträgerstruktur 110 vor dem Füllen der Zwischenräume 112 mit Konvertermaterial 114 gekappt wurden (z.B. durch Ätzen, Polieren oder mittels Focussed Ion Beam (FIB)-Verfahren). Die Innenfläche 110a ist frei von Konvertermaterial.

Aus Fig. 5h und Fig. 5i ist auch gut ersichtlich, dass mittels einer gemischt facettierten Säulentexturierung bzw. durch Kappen der Spitzen größere zusammenhängende Konvertermaterialbereiche (Pixel) erzeugt werden können.

Fig. 5j zeigt einen Konverter 125 mit einer Diamantträgerstruktur 120, die der Diamantträgerstruktur 60 aus Fig. 5e entspricht, wobei das Konvertermaterial 124 auf den Plateaus 122 der gekappten Spitzen der Diamantsäulenkristalle 123 auf der Außenfläche 120b der Diamantträgerstruktur 120 aufgebracht ist. Die Innenfläche 120a ist frei von Konvertermaterial. Das Konvertermaterial 124 kann auf den Plateaus beispielsweise wie folgt aufgebracht werden: zuerst wird die Außenfläche 120b ganzflächig mit einem Metall beschichtet. Anschließend werden die Spitzen durch Polieren gekappt und die Plateaus dadurch von Metall freigestellt. Dann wird das Konvertermaterial ganzflächig durch ein CVD-Verfahren auf der Außenfläche 120b als Schicht von 100 bis 500 µm abgeschieden. Durch nachfolgendes Auflösen des Metalls wird das Metall und das Konvertermaterial in den Tälern zwischen den Plateaus 122 entfernt.

Wie aus den Fig. 5a - 5j gut ersichtlich ist, verbleiben zwischen den mit Konvertermaterial 24, 34, 44, 54, 64, 74, 84, 94, 114, 124 versehenen Bereichen 22, 32, 42, 52, 62, 72, 82, 92, 112, 122 auf den Innen- bzw. Außenflächen 20a, 20b, 30a, 30b, 40a, 40b, 50a, 50b, 60a, 60b, 70a, 70b, 80a, 80b, 90a, 90b, 110a, 110b, 120a, 120b der jeweiligen Diamantträgerstrukturen 20, 30, 40, 50, 60, 70, 80, 90, 110, 120 Freiräume, die einen konversionsfreien Durchtritt des Primärlichts durch die Diamantträgerstrukturen 20, 30, 40, 50, 60, 70, 80, 90, 110, 120 ermöglichen.

Die oben gezeigten Beispiele für erfindungsgemäße Konverter sind nur einige unter vielen und daher nicht als einschränkend zu betrachten.

## Patentansprüche

1. Konverter (25, 35, 45, 55, 65, 75, 85, 95, 115, 125) für eine Leuchtvorrichtung, insbesondere für eine Leuchtvorrichtung für einen Kraftfahrzeugscheinwerfer, wobei der Konverter ein Konvertermaterial (24, 34, 44, 54, 64, 74, 84, 94,114,124) zur zumindest teilweisen Umwandlung eines von einer Primärlichtquelle ausgestrahlten Primärlichts in ein Sekundärlicht aufweist, wobei das Sekundärlicht eine unterschiedliche Wellenlänge als das Primärlicht aufweist,
**dadurch gekennzeichnet, dass**
der Konverter eine flächige Diamantträgerstruktur (20, 30, 40, 50, 60, 70, 80, 90, 110, 120) aus polykristallinem Diamant mit einer Vielzahl an Diamantsäulenkristallen (23, 33, 43, 53, 63, 73, 83, 93, 113, 123), die eine Diamantsäulentextur ausbilden, umfasst, wobei Bereiche (22, 32, 42, 52, 62, 72, 82, 92, 112, 122) der Diamantträgerstruktur das Konvertermaterial (24, 34, 44, 54, 64, 74, 84, 94, 114, 124) aufweisen und zwischen diesen Bereichen Freiräume verbleiben, die einen konversionsfreien Durchtritt des Primärlichts durch die Diamantträgerstruktur ermöglichen.

2. Konverter nach Anspruch 1, **dadurch gekennzeichnet, dass** die das Konvertermaterial aufweisenden Bereiche (22, 32, 42, 52, 62, 72, 82, 92, 112, 122) der flächigen Diamantträgerstruktur (20, 30, 40, 50, 60, 70, 80, 90, 110, 120) der Topografie der flächigen Diamantträgerstruktur folgen.

3. Konverter nach Anspruch 1 oder 2, **dadurch gekennzeichnet, dass** die Diamantsäulenkristalle (23, 33, 43, 53, 63, 73, 83, 93, 113, 123) in der flächigen Diamantträgerstruktur (20, 30, 40, 50, 60, 70, 80, 90, 110, 120) im Wesentlichen in Lichtausbreitungsrichtung ausgerichtet sind.

4. Konverter nach einem der Ansprüche 1 bis 3, **dadurch gekennzeichnet, dass** Zwischenräume (22, 32, 42, 52, 62, 72, 92, 112) der Diamantträgerstruktur (20, 30, 40, 50, 60, 70, 90, 110) zumindest teilweise mit dem Konvertermaterial (24, 34,44, 54, 64, 74, 94,114) gefüllt sind.

5. Konverter nach Anspruch 4, **dadurch gekennzeichnet, dass** die flächige Diamantträgerstruktur (20, 30,40,50, 60, 70, 90,110) eine Innenfläche (20a, 30a, 40a, 50a, 60a, 70a, 90a, 110a) und eine Außenfläche (20b, 30b, 40b, 50b, 60b, 70b, 90b, 110b) aufweist, wobei Zwischenräume auf zumindest einer der Flächen der Diamantträgerstruktur zumindest teilweise mit Konvertermaterial (24, 34, 44, 54, 64, 74, 94, 114) gefüllt sind.

6. Konverter nach Anspruch 5, **dadurch gekennzeichnet, dass** die Zwischenräume (22, 32) auf der Innenfläche (20a, 30a) der Diamantträgerstruktur (20, 30) zumindest teilweise mit Konvertermaterial (24, 34) gefüllt sind oder dass die Zwischenräume auf beiden Flächen (30a) der flächigen Diamantträgerstruktur (30) zumindest teilweise mit Konvertermaterial (34) gefüllt sind.

7. Konverter nach einem der Ansprüche 1 bis 3, **dadurch gekennzeichnet, dass** die flächige Diamantträgerstruktur (80, 120) eine Innenfläche (80a, 120a) und eine Außenfläche (80b, 120b) aufweist, wobei das Konvertermaterial (84,124) auf Erhebungen (82,122) auf zumindest einer der Flächen der Diamantträgerstruktur zumindest teilweise aufgebracht ist, wobei das Konvertermaterial (84,124) vorzugsweise auf Erhebungen (82,122) auf der Außenfläche (80b, 120b) der Diamantträgerstruktur (80, 120) zumindest teilweise aufgebracht ist.

8. Leuchtvorrichtung für einen Kraftfahrzeugscheinwerfer umfassend eine Primärlichtquelle und einen Konverter (25, 35, 45, 55, 65, 75, 85, 95, 115, 125) nach einem der Ansprüche 1 bis 7, wobei die Primärlichtquelle vorzugsweise eine Laserlichtquelle, mehr bevorzugt eine Laserlichtquelle, die blaues Licht emittiert, ist.

9. Kraftfahrzeugscheinwerfer umfassend einen Konverter (25, 35, 45, 55, 65, 75, 85, 95, 115,125) nach einem der Ansprüche 1 bis 7 bzw. eine Leuchtvorrichtung nach Anspruch 8.

10. Verfahren zum Herstellen eines Konverters für eine Leuchtvorrichtung nach einem der Ansprüche 1 bis 7, **gekennzeichnet durch** die folgenden Schritte:
a) Herstellen einer flächigen polykristallinen Diamantträgerstruktur auf einem flächigen Substrat mittels chemischer Abscheidung aus der Gasphase (Chemical Vapor Deposition, CVD),
b) zumindest teilweises Aufbringen von Konvertermaterial in Bereichen der Diamantträgerstruktur, wobei zwischen den das Konvertermaterial aufweisenden Bereichen Freiräume verbleiben, die einen konversionsfreien Durchtritt des Primärlichts durch die Diamantträgerstruktur ermöglichen, und
gegebenenfalls Lösen des flächigen Substrats von der polykristallinen Diamantträgerstruktur nach dem Schritt a) oder nach dem Schritt b),
wobei die das Konvertermaterial aufweisenden Bereiche vorzugsweise aus der Gruppe bestehend aus Zwischenräumen und Erhebungen der Diamantträgerstruktur ausgewählt sind.

11. Verfahren nach Anspruch 10, **dadurch gekennzeichnet, dass** das Konvertermaterial durch chemische Abscheidung gasförmiger Reaktanten oder durch Materialabscheidung, beispielsweise Sputtern oder Spraycoaten, aufgebracht wird oder dass das Konvertermaterial in einer festen, flüssigen oder gelförmigen Vorform aufgebracht und anschließend in eine feste Phase, die mit der Diamanträgerstruktur verbunden ist, umgewandelt wird.

12. Verfahren zum Herstellen eines Konverters für eine Leuchtvorrichtung nach einem der Ansprüche 1 bis 7, **gekennzeichnet durch** die folgenden Schritte:
a) Herstellen einer strukturierten Konvertermaterialschicht auf einem flächigen Substrat,
b) Abscheiden einer flächigen polykristallinen Diamantträgerstruktur auf dem die strukturierte Konvertermaterialschicht aufweisenden Substrat mittels chemischer Abscheidung aus der Gasphase (Chemical Vapor Deposition, CVD), und
gegebenenfalls Lösen des flächigen Substrats von der polykristallinen, das Konvertermaterial aufweisenden Diamantträgerstruktur nach dem Schritt b).

13. Verfahren nach Anspruch 12, **dadurch gekennzeichnet, dass** das Konvertermaterial durch chemische Abscheidung aus der Gasphase (Chemical Vapor Deposition, CVD) in Verbindung mit fotolithographischen Verfahren, physikalische Materialabscheidung wie Physical Vapor Deposition (PVD) in Verbindung mit fotolithographischen Verfahren, oder durch strukturiertes Aufdrucken auf dem Substrat aufgebracht wird.

14. Verfahren nach einem der Ansprüche 10 bis 13, **dadurch gekennzeichnet, dass** die chemische Abscheidung der Diamantträgerstruktur aus der Gasphase auf einer gezielten Keimung der Diamantkristalle auf dem Substrat basiert, wobei das Substrat oder die Substratoberfläche aus einem Fremdmaterial gefertigt ist, wobei das Substrat vorzugsweise aus der Gruppe bestehend aus Silizium, einem Element aus der Gruppe der Refraktärmetalle (Ti, Zr, Hf, Va, Nb, Ta, Cr, Mo und W), insbesondere Molybdän, Carbiden von Silizium, Carbiden von einem Element aus der Gruppe der Refraktärmetalle (Ti, Zr, Hf, Va, Nb, Ta, Cr, Mo und W), Silizium mit carbidisierter Oberfläche und einem Element aus der Gruppe der Refraktärmetalle (Ti, Zr, Hf, Va, Nb, Ta, Cr, Mo und W) mit carbidisierter Oberfläche gefertigt ist.

15. Verfahren nach einem der Ansprüche 10 bis 13, **dadurch gekennzeichnet, dass** die chemische Abscheidung der Diamantträgerstruktur aus der Gasphase auf Grundlage eines Homoepitaxieprozesses erfolgt, wobei das Substrat vorzugsweise aus HPHT-Diamant, oder, mehr bevorzugt aus polierten, Natur- oder CVD-Diamantsubstraten ausgewählt ist.

16. Konverter nach einem der Ansprüche 1 bis 7 bzw. Verfahren nach einem der Ansprüche 10 bis 15, **dadurch gekennzeichnet, dass** das Konvertermaterial aus der Gruppe bestehend aus Cer-dotiertem YAG (Yttrium Aluminium Granat, Lanthan dotiertem Yttriumoxid (Y₂O₃-La₂O₃), Magnesium Aluminium Spinell (MgAl₂O₄) und Europium-dotiertem M₂Si₅N₈ mit M = Ca, Sr oder Ba ausgewählt ist.

## Claims

1. A converter (25, 35, 45, 55, 65, 75, 85, 95, 115, 125) for a lighting device, in particular for a lighting device for a motor vehicle headlight, wherein the converter comprises a converter material (24, 34, 44, 54, 64, 74, 84, 94, 114, 124) for at least partly converting a primary light, which is emitted from a primary light source, into a secondary light, wherein the secondary light has a different wavelength than the primary light,
**characterised in that**
the converter comprises a flat diamond support structure (20, 30,40, 50, 60, 70, 80, 90, 110, 120) made of polycrystalline diamond with a plurality of column-shaped diamond crystals (23, 33, 43, 53, 63, 73, 83, 93,113,123), which form a column-shaped diamond texture, wherein regions (22, 32, 42, 52, 62, 72, 82, 92,112,122) of the diamond support structure comprise the converter material (24, 34, 44, 54, 64, 74, 84, 94, 114, 124), and free spaces remain between said regions, the free spaces allow the primary light to pass through the diamond support structure without being converted.

2. The converter according to claim 1, **characterised in that** the regions (22, 32, 42, 52, 62, 72, 82, 92, 112, 122) of the flat diamond support structure (20, 30, 40, 50, 60, 70, 80, 90, 110, 120) comprising the converter material follow the topography of the flat diamond support structure.

3. The converter according to claim 1 or 2, **characterised in that** the column-shaped diamond crystals (23, 33, 43, 53, 63, 73, 83, 93, 113, 123) in the flat diamond support structure (20, 30, 40, 50, 60, 70, 80, 90, 110, 120) are oriented substantially in the direction of light propagation.

4. The converter according to any one of claims 1 to 3, **characterised in that** gaps (22, 32, 42, 52, 62, 72, 92, 112) in the diamond support structure (20, 30, 40, 50, 60, 70, 90, 110) are filled at least in part with the converter material (24, 34, 44, 54, 64, 74, 94, 114).

5. The converter according to claim 4, **characterised in that** the flat diamond support structure (20, 30, 40, 50, 60, 70, 90, 110) has an inner face (20a, 30a, 40a, 50a, 60a, 70a, 90a, 110a) and an outer face (20b, 30b, 40b, 50b, 60b, 70b, 90b, 110b), wherein gaps on at least one of the faces of the diamond support structure are filled at least in part with converter material (24, 34, 44, 54, 64, 74, 94,114).

6. The converter according to claim 5, **characterised in that** the gaps (22, 32) on the inner face (20a, 30a) of the diamond support structure (20, 30) are filled at least in part with converter material (24, 34), or **in that** the gaps on both faces (30a) of the flat diamond support structure (30) are filled at least in part with converter material (34).

7. The converter according to any one of claims 1 to 3, **characterised in that** the flat diamond support structure (80, 120) has an inner face (80a, 120a) and an outer face (80b, 120b), wherein the converter material (84, 124) is applied at least in part to elevations (82, 122) on at least one of the faces of the diamond support structure, wherein the converter material (84, 124) preferably is applied at least in part to elevations (82, 122) on the outer face (80b, 120b) of the diamond support structure (80, 120).

8. A lighting device for a motor vehicle headlight comprising a primary light source and a converter (25, 35, 45, 55, 65, 75, 85, 95, 115, 125) according to any one of claims 1 to 7, wherein the primary light source preferably is a laser light source, more preferably a laser light source emitting blue light.

9. A motor vehicle headlight comprising a converter (25, 35, 45, 55, 65, 75, 85, 95, 115, 125) according to any one of claims 1 to 7 and/or a lighting device according to claim 8.

10. A method for producing a converter for a lighting device according to any one of claims 1 to 7, **characterised by** the following steps:
a) producing a flat polycrystalline diamond support structure on a flat substrate by means of chemical vapour deposition (CVD),
b) at least partially applying converter material in regions of the diamond support structure, wherein free spaces remain between the regions having the converter material, and the free spaces allow the primary light to pass through the diamond support structure without being converted, and
optionally detaching the flat substrate from the polycrystalline diamond support structure after step a) or after step b),
wherein the regions having the converter material are preferably selected from the group consisting of gaps and elevations of the diamond support structure.

11. The method according to claim 10, **characterised in that** the converter material is applied by chemical deposition of gaseous reactants or by material deposition, for example sputtering or spray-coating, or **in that** the converter material is applied in a solid, liquid or gel-like preform and is then converted into a solid phase connected to the diamond support structure.

12. A method for producing a converter for a lighting device according to any one of claims 1 to 7, **characterised by** the following steps:
a) producing a structured converter material layer on a flat substrate,
b) depositing a flat polycrystalline diamond support structure on the substrate having the structured converter material layer by means of chemical vapour deposition (CVD), and
optionally detaching the flat substrate from the polycrystalline diamond support structure having the converter material after step b).

13. The method according to claim 12, **characterised in that** the converter material is applied to the substrate by chemical vapour deposition (CVD) in conjunction with photolithographic methods, physical material deposition, such as physical vapour deposition (PVD) in conjunction with photolithographic methods, or by structured printing.

14. The method according to any one of claims 10 to 13, **characterised in that** the chemical vapour deposition of the diamond support structure is based on a selective seeding of the diamond crystals on the substrate, wherein the substrate or the substrate surface is produced from a foreign material, wherein the substrate is preferably selected from the group consisting of silicon, an element from the group of refractory metals (Ti, Zr, Hf, Va, Nb, Ta, Cr, Mo and W), in particular molybdenum, silicon carbides, carbides of an element from the group of refractory metals (Ti, Zr, Hf, Va, Nb, Ta, Cr, Mo and W), silicon with carbidised surface, and an element from the group of refractory metals (Ti, Zr, Hf, Va, Nb, Ta, Cr, Mo and W) with carbidised surface.

15. The method according to any one of claims 10 to 13, **characterised in that** the diamond support structure is deposited by chemical vapour deposition on the basis of a homoepitaxial process, wherein the substrate is preferably selected from HPHT diamond or more preferably selected from polished natural or CVD diamond substrates.

16. The converter according to any one of claims 1 to 7 or the method according to any one of claims 10 to 15, **characterised in that** the converter material is selected from the group consisting of Cer-doped YAG (yttrium aluminium garnet, lanthanum-doped yttrium oxide (Y₂O₃-La₂O₃), magnesium aluminium spinel (MgAl₂O₄) and europium-doped M₂Si₅N₈ with M = Ca, Sr or Ba.

## Revendications

1. Convertisseur (25, 35, 45, 55, 65, 75, 85, 95, 115, 125) pour un dispositif d'éclairage, en particulier pour un dispositif d'éclairage pour un phare de véhicule automobile, le convertisseur présentant une matière de convertisseur (24, 34, 44, 54, 64, 74, 84, 94, 114, 124) pour la conversion au moins partielle d'une lumière primaire émise par une source de lumière primaire en une lumière secondaire, la lumière secondaire présentant une longueur d'onde différente de celle de la lumière primaire,
**caractérisé par le fait que**
le convertisseur comporte une structure porteuse diamant plane (20, 30, 40, 50, 60, 70, 80, 90, 110, 120) en diamant polycristallin avec une pluralité de cristaux de colonnes de diamant (23, 33, 43, 53, 63, 73, 83, 93, 113, 123), qui forment une texture de colonnes de diamant, des zones (22, 32, 42, 52, 62, 72, 82, 92, 112, 122) de la structure porteuse diamant présentant la matière de convertisseur (24, 34, 44, 54, 64, 74, 84, 94, 114, 54) et des espaces libres subsistant entre ces zones, lesquels permettent un passage sans conversion de la lumière primaire à travers la structure porteuse diamant.

2. Convertisseur selon la revendication 1, **caractérisé par le fait que** les zones (22, 32, 42, 52, 62, 72, 82, 92, 112, 122) présentant la matière de convertisseur de la structure porteuse diamant (20, 30, 40, 50, 60, 70, 80, 90, 110, 120) suivent la topographie de la structure porteuse diamant plane.

3. Convertisseur selon l'une des revendications 1 et 2, **caractérisé par le fait que** les cristaux de colonnes de diamant (23, 33, 43, 53, 63, 73, 83, 93, 113, 123) dans la structure porteuse diamant plane (20, 30, 40, 50, 60, 70, 80, 90, 110, 120) sont orientés sensiblement dans la direction de propagation de la lumière.

4. Convertisseur selon l'une des revendications 1 à 3, **caractérisé par le fait que** des espaces intermédiaires (22, 32, 42, 52, 62, 72, 92, 112) de la structure porteuse diamant (20, 30, 40, 50, 60, 70, 90, 110) sont remplis au moins partiellement par la matière de convertisseur (24, 34, 44, 54, 64, 74, 94, 114).

5. Convertisseur selon la revendication 4, **caractérisé par le fait que** la structure porteuse diamant plane (20, 30, 40, 50, 60, 70, 90, 110) présente une surface interne (20a, 30a, 40a, 50a, 60a, 70a, 90a, 100a) et une surface externe (20b, 30b, 40b, 50b, 60b, 70b, 90b, 100b), des espaces intermédiaires sur au moins l'une des surfaces de la structure porteuse diamant étant remplis au moins partiellement par de la matière de convertisseur (24, 34, 44, 54, 64, 74, 94, 114).

6. Convertisseur selon la revendication 5, **caractérisé par le fait que** les espaces intermédiaires (22, 32) sur la surface interne (20a, 30a) de la structure porteuse diamant (20, 30) sont remplis au moins partiellement par de la matière de convertisseur (24, 34) ou **par le fait que** les espaces intermédiaires sur les deux surfaces (30a) de la structure porteuse diamant plane (30) sont remplis au moins partiellement par de la matière de convertisseur (34).

7. Convertisseur selon l'une des revendications 1 à 3, **caractérisé par le fait que** la structure porteuse diamant plane (80, 120) présente une surface interne (80a, 120a) et une surface externe (80b, 120b), la matière de convertisseur (84, 124) étant appliquée au moins partiellement sur des élévations (82, 122) sur au moins l'une des surfaces de la structure porteuse diamant, la matière de convertisseur (84, 124) étant appliquée au moins partiellement, de préférence sur des élévations (82, 122) sur la surface externe (80b, 120b) de la structure porteuse diamant (80, 120).

8. Dispositif d'éclairage pour un phare de véhicule automobile comportant une source de lumière primaire et un convertisseur (25, 35, 45, 55, 65, 75, 85, 95, 115, 125) selon l'une des revendications 1 à 7, dans lequel la source de lumière primaire est, de préférence, une source de lumière laser, de manière davantage préférée une source de lumière laser qui émet de la lumière bleue.

9. Phare de véhicule automobile comportant un convertisseur (25, 35, 45, 55, 65, 75, 85, 95, 115, 125) selon l'une des revendications 1 à 7 ou un dispositif d'éclairage selon la revendication 8.

10. Procédé de fabrication d'un convertisseur pour un dispositif d'éclairage selon l'une des revendications 1 à 7, **caractérisé par** les étapes suivantes :
a) formation d'une structure porteuse diamant polycristalline plane sur un substrat plan au moyen d'un dépôt chimique en phase vapeur (Chemical Vapor Deposition, CVD) ;
b) application au moins partielle de matière de convertisseur dans des zones de la structure porteuse diamant, des espaces libres subsistant entre les zones présentant la matière de convertisseur, lesquels permettent un passage sans conversion de la lumière primaire à travers la structure porteuse diamant ; et
le cas échéant, détachement du substrat plan de la structure porteuse diamant après l'étape a) ou après l'étape b),
dans lequel les zones présentant la matière de convertisseur sont, de préférence, choisies dans le groupe consistant en espaces intermédiaires et élévations de la structure porteuse diamant.

11. Procédé selon la revendication 10, **caractérisé par le fait que** la matière de convertisseur est appliquée par dépôt chimique de réactifs gazeux ou par dépôt de matière, par exemple pulvérisation cathodique ou revêtement par pulvérisation, ou **par le fait que** la matière de convertisseur est appliquée dans une forme solide, liquide ou gélifiée et est ensuite convertie en une phase solide, qui est liée à la structure porteuse diamant.

12. Procédé de fabrication d'un convertisseur pour un dispositif d'éclairage selon l'une des revendications 1 à 7, **caractérisé par** les étapes suivantes :
a) formation d'une couche de matière de convertisseur structurée sur un substrat plan ;
b) dépôt d'une structure porteuse diamant polycristalline plane sur le substrat présentant la matière de convertisseur structurée au moyen du dépôt chimique en phase vapeur (Chemical Vapor Deposition, CVD) ; et
le cas échéant, détachement du substrat plan de la structure porteuse diamant présentant la matière de convertisseur, polycristalline, après l'étape b).

13. Procédé selon la revendication 12, **caractérisé par le fait que** la matière de convertisseur est appliquée par dépôt chimique en phase vapeur (Chemical Vapor Deposition, CVD) en liaison avec un procédé photolithographique, un dépôt de matière physique comme le dépôt physique en phase vapeur (Physical Vapor Deposition, PVD) en liaison avec un procédé photolithographique, ou par application structurée sur le substrat.

14. Procédé selon l'une des revendications 10 à 13, **caractérisé par le fait que** le dépôt chimique de la structure porteuse diamant à partir de la phase gazeuse est basé sur une germination ciblée des cristaux de diamant sur le substrat, le substrat ou la surface du substrat étant réalisé(e) à partir d'une matière étrangère, le substrat étant réalisé, de préférence, à partir du groupe consistant en le silicium, un élément du groupe des métaux réfractaires (Ti, Zr, Hf, Va, Nb, Ta, Cr, Mo et W), en particulier le molybdène, les carbures de silicium, les carbures d'un élément du groupe des métaux réfractaires (Ti, Zr, Hf, Va, Nb, Ta, Cr, Mo et W), le silicium avec une surface carburée et un élément du groupe des métaux réfractaires (Ti, Zr, Hf, Va, Nb, Ta, Cr, Mo et W) avec une surface carburée.

15. Procédé selon l'une des revendications 10 à 13, **caractérisé par le fait que** le dépôt chimique de la structure porteuse diamant à partir de la phase gazeuse a lieu sur la base d'un procédé d'homo-épitaxie, le substrat étant, de préférence, choisi parmi le diamant HPHT, ou, de façon davantage préférée, parmi les substrats de diamant polis, naturels ou de CVD.

16. Convertisseur selon l'une des revendications 1 à 7 ou procédé selon l'une des revendications 10 à 15, **caractérisé par le fait que** la matière de convertisseur est choisie dans le groupe consistant en le YAG (Yttrium Aluminium Grenat) dopé au Cer, l'oxyde d'yttrium dopé au lanthane (Y₂O₃-La₂O₃), le spinelle d'oxyde de magnésium et d'aluminium (MgAl₂O₃) et M₂Si₅N₈ dopé à l'europium avec M = Ca, Sr ou Ba.
